# FASCICULE DE BREVET EUROPEEN

(11) **EP 4 466 548 B1**
(45) Date de publication et mention de la délivrance du brevet: **24.12.2025**
(21) Numéro de dépôt: 22826141.8
(22) Date de dépôt: 21.11.2022
(51) Int. Cl.: G01R 31/52, B60L 3/00

(54) **PROCEDE DE SURVEILLANCE D'UN DEFAUT D'ISOLATION DANS UN CIRCUIT DE RECHARGE**
VERFAHREN ZUR ÜBERWACHUNG VON ISOLATIONSFEHLER IN EINER LADESCHALTUNG
PROCESS FOR INSULATION DEFAULT MONITORING IN A LOADING CIRCUIT

(30) Priorité: 18.01.2022 FR 2200408
(43) Date de publication de la demande: 27.11.2024
(73) Titulaire: Stellantis Auto SAS, 78300 Poissy (FR)
(72) Inventeur: BALENGHIEN, Olivier, 93390 CLICHY SOUS BOIS (FR)
(74) Mandataire: PSIP
(86) Numéro de dépôt international: PCT/FR2022/052142
(87) Numéro de publication internationale: WO 2023/139317

(56) Documents cités:
- EP-A1- 3 912 843
- FR-A1- 3 037 406
- US-A1- 2018 105 060
- US-A1- 2021 129 675

## Description

### DOMAINE TECHNIQUE DE L'INVENTION

L'invention concerne, de façon générale, le domaine technique de la détection et surveillance d'un défaut d'isolation dans un circuit de recharge d'un pack batterie. Ces packs batteries sont utilisés dans des véhicules électriques ou hybrides, c'est-à-dire mus au moins partiellement par de l'énergie électrique.

On entend par véhicules hybrides, des véhicules tractés ou propulsés par un moteur thermique classique et un moteur électrique (ou machine électrique).

### ETAT DE LA TECHNIQUE ANTERIEURE

Les véhicules automobiles à traction ou propulsion électrique ou hybride, comportent un ou plusieurs modules de batteries (ou de puissance) reliés à un réseau de puissance pour alimenter un moteur électrique (de traction ou de propulsion).

Les modules de batteries sont regroupés dans un carter et forment alors un bloc batterie aussi souvent désigné par l'expression anglaise « pack batterie », ce carter contenant généralement une interface de montage, et des bornes de raccordement.

On comprendra donc par pack batterie, dans tout le texte de ce document, un ensemble comprenant au moins un module de batterie contenant au moins une cellule électrochimique. Ce pack batterie comprend un moyen de gestion électrique ou électronique des batteries (ou calculateur de pilotage), aussi appelé BMS (Acronyme en anglais de Battery Management System). Le moyen de gestion électrique est piloté par une unité de supervision du véhicule eVCU (Acronyme en anglais de electronic Vehicle Control Unit). L'eVCU pilote entre autre un réseau de communication CAN (Acronyme en anglais de Controller Area Network), un moyen de contrôle du chargeur embarqué OBC (Acronyme en anglais de On Board Charging) et un moyen de contrôle du convertisseur appelé OBCDC (Acronyme en anglais de On Board Charging DC-DC Converters).

Le moyen de contrôle de convertisseur OBCDC est composé de deux parties dont le moyen de contrôle du chargeur embarqué OBC et un convertisseur DC/DC qui est responsable de la conversion du courant.

Le moyen de contrôle du chargeur embarqué OBC est le chargeur de courant électrique du véhicule. L'OBC gère la communication avec les différentes bornes de recharge. L'OBC surveille et monitore également la recharge électrique du véhicule.

Le convertisseur DC/DC est responsable de la conversion du courant. Lors des recharges électriques selon des premier et deuxième modes de recharge domestique comme décrit ci-après, le convertisseur DC/DC convertit le courant alternatif 220V en courant continu jusque 450V sur les véhicules.

En roulage, le convertisseur DC/DC convertit le courant continue DC qui présente une tension de 450V en courant continu DC présentant une tension de 12V pour soutenir la tension du réseau de bord du véhicule et recharger la batterie de servitude de 12V. La batterie de servitude de 12V alimente la climatisation, la radio et l'éclairage habitacle, par exemple.

Par ailleurs, on comprendra par cellule électrochimique des cellules générant du courant par réaction chimique, par exemple de type lithium-ion (ou Li-ion), de type Ni-Mh, ou Ni-Cd ou plomb ou encore des cellules de pile à combustible.

Le pack batterie est relié à une embase de recharge du véhicule par un circuit de recharge comprenant un ensemble de contacteurs ou relais. Plus précisément, le pack batterie comprend un premier connecteur électrique relié à un deuxième connecteur électrique prévu sur l'embase de recharge, par un câble ou faisceau électrique. Pour recharger le véhicule, l'embase de recharge est connectée à un pistolet de recharge d'un dispositif de recharge tel une station ou borne ou prise de recharge.

Il existe plusieurs modes de recharge dont un premier mode de recharge domestique (appelé charge mode 2) sur une prise murale classique délivrant généralement un courant compris entre 8A et 13A sous la tension standard du réseau électrique domestique de 220V alternatif.

Il existe également un deuxième mode de recharge (appelé charge mode 3) sur une wallbox (boîte murale en français). Cette wallbox est en général achetée avec le véhicule et installée sur le compteur du domicile de l'utilisateur du véhicule, c'est-à-dire qu'elle est alimentée en énergie électrique domestique, et elle délivre donc un courant en monophasé de 16A ou de 32A ou en triphasé de 16A sur chaque phase. La wallbox joue donc un rôle comparable à celui d'un convertisseur électrique.

Il existe également un troisième mode de recharge (appelé charge mode 4) sur des bornes spéciales délivrant généralement un courant continu de plus de 40A (125A ou 250A en général) sous une tension de variable pouvant aller jusqu'à 450V. Ce mode de recharge sur borne spéciale est aussi appelé mode de recharge rapide et est indépendant du réseau électrique domestique.

Les deux premiers modes de recharge sont pilotés par l'OBCDC comme expliqué précédemment et le troisième mode de recharge (mode 4) est piloté par le BMS.

Chaque module de batterie est relié au moteur électrique par un circuit de décharge comprenant également un ensemble de contacteurs ou relais.

Actuellement, il existe des règlementations concernant la disposition du cheminement des câbles ou faisceaux électriques reliant le connecteur dit étanche au pack batterie pour éviter l'oxydation du connecteur.

Le courant dans le pack batterie peut atteindre les 450 V en courant continu DC. L'oxydation du connecteur entraînerait ainsi des risques de court-circuit qui peuvent créer des surtensions et faire sauter les fusibles de sécurité, voir créer des arcs électriques qui peuvent causer des risques d'incendie dans le véhicule.

Une des règles simples consiste à courber le câble électrique en créant un point bas sur le cable, avant son arrivée au connecteur pour éviter que l'eau ne coule le long du câble électrique et ne rentre directement dans le connecteur.

Cependant, à cause de la garde au sol assez basse sur certains véhicules, le câble électrique ne peut pas arriver par le bas pour ne pas risquer d'être endommagé par les gravillons de la route. De plus, le câble électrique est trop gros pour être courbé correctement. Il serait nécessaire d'appliquer une grande courbure au câble électrique, ce qui entraînerait des coûts supplémentaires dus à la longueur de câble électrique supplémentaire et poserait des problèmes d'encombrement.

Une solution consiste à faire arriver le câble électrique par le dessus du connecteur et d'utiliser un connecteur dit étanche pour éviter que l'eau ne l'agresse.

Cette solution n'est cependant pas entièrement efficace car le circuit de recharge et les contacteurs de recharges sous toujours susceptibles d'être oxydés.

Il existe des procédés de surveillance dans lesquels le BMS mesure la valeur de la résistance du circuit de recharge permettant une recharge rapide (en mode 4). Si la résistance mesurée est inférieure à une résistance limite, le BMS stoppe la recharge rapide.

Cependant, lorsque le BMS détecte un défaut d'isolation lors d'une charge rapide, il ne sait pas reconnaître si le défaut d'isolation provient du côté de la borne de recharge (beaucoup de bornes de recharge présentant des défauts d'isolation) ou du côté du véhicule à cause d'une oxydation du premier connecteur du pack batterie ou des contacteurs.

On connaît également le document CN111458652A qui décrit un procédé de détection de défaut d'isolation. Lors d'un processus de charge d'un véhicule électrique, le système effectue un test de la résistance du courant de charge. Si le taux de distorsion de la forme d'onde de tension et le taux de distorsion de la forme d'onde de courant dépassent des seuils prédéterminés, il est déterminé que la prise de charge présente une défaillance due à l'oxydation.

Plusieurs étapes de tests permettent d'effectuer un diagnostic précis, donnant lieu à des actions précises, comme le maintien de la charge, l'arrêt immédiat, et/ou la demande de remplacement de la prise de charge.

Cependant, le contrôle d'un défaut d'isolation du circuit de recharge permettant une recharge rapide est réalisé pendant la charge, ce qui ne permet pas au BMS de distinguer si le défaut d'isolation provient du côté de la borne de recharge ou du côté du véhicule.

Ce défaut de distinction, comme avec la méthode précédemment décrite, entraîne des coûts de garantie importants car le circuit de charge et le connecteur sont remplacés systématiquement sur le véhicule lorsque qu'un défaut d'isolation est détecté, alors que le défaut provient en réalité dans 99% des cas de la borne de recharge.

De plus, cette méthode nécessite d'utiliser des capteurs spécifiques, ce qui entraîne un coût supplémentaire.

En outre l'état de la technique est connu du document US2018105060A1.

### EXPOSE DE L'INVENTION

L'invention vise à remédier à tout ou partie des inconvénients de l'état de la technique en proposant notamment une solution permettant de détecter un défaut d'isolation dans un circuit de recharge d'un pack batterie plus efficacement.

Pour ce faire, il est proposé, selon un premier aspect de l'invention, un procédé de surveillance d'un défaut d'isolation dans un circuit de recharge d'un pack batterie destiné à alimenter un moteur électrique d'un véhicule mû au moins partiellement par de l'énergie électrique. Le pack batterie comprend au moins un module de batterie et un moyen de gestion pilotant le module de batterie. Le module de batterie est apte à être relié au moteur électrique par un circuit de décharge comprenant un premier ensemble de contacteurs et apte à être relié à une embase de recharge par le circuit de recharge comprenant un deuxième ensemble de contacteurs. L'embase de recharge est destinée à être connectée à un pistolet de recharge d'un dispositif de recharge électrique pour recharger le module de batterie.

Le procédé de surveillance comprend une opération de détection du défaut d'isolation dans le circuit de recharge lors d'une phase de roulage du véhicule durant laquelle le deuxième ensemble de contacteurs est fermé pour relier électriquement le module de batterie à l'embase de recharge. Le premier ensemble de contacteurs est également fermé pour relier électriquement le module de batterie au moteur électrique pour permettre le roulage.

Selon un mode de réalisation, lors de l'opération de détection, le moyen de gestion mesure un courant I et une tension U dans le circuit de recharge pour déterminer une résistance R d'après la relation R = U / I. Un défaut d'isolation dans le circuit de recharge est détecté lorsque la résistance R mesurée est inférieure ou égale à une valeur de résistance seuil Rs.

Selon un autre mode de réalisation, le courant I et la tension U sont mesurés en sortie du pack batterie.

Selon un autre mode de réalisation, l'opération de détection est réalisée pendant un temps de test T1 déterminé. Le défaut d'isolation dans le circuit de recharge est détecté lorsque la résistance R mesurée est inférieure ou égale à la valeur de résistance seuil Rs pendant un temps T2, T2 étant inférieur au temps T1.

Selon un autre mode de réalisation, le circuit de recharge comprend un chemin de recharge positif connecté à une borne d'électrode positive du module de batterie et un chemin de recharge négatif connecté à une borne d'électrode négative du module de batterie. Le chemin de recharge positif comprend un premier contacteur positionné entre la borne d'électrode positive et un premier connecteur électrique relié à l'embase de recharge et un deuxième contacteur positionné entre la borne d'électrode négative et le premier connecteur électrique. Le premier contacteur est fermé pour relier électriquement le chemin de décharge positif à l'embase de recharge. Le deuxième contacteur est fermé pour relier électriquement le chemin de décharge négatif à l'embase de recharge, lors de l'opération de détection.

Selon un autre mode de réalisation, l'opération de détection est réalisée une seule fois après le démarrage du véhicule et après un temps T3 après le démarrage du véhicule. Ceci permet d'éviter d'user les premier et deuxième contacteurs.

En variante, l'opération de détection est réalisée plusieurs fois après le démarrage du véhicule et après un temps T3 après le démarrage du véhicule à une fréquence définie lors d'une phase de mise au point de la fonction.

Selon un autre mode de réalisation, lorsqu'un défaut d'isolation dans le circuit de recharge est détecté, le moyen de gestion interdit la recharge du pack batterie en mode rapide.

Selon un autre mode de réalisation, lorsqu'un défaut d'isolation dans le circuit de recharge est détecté, le moyen de gestion transmet une alerte à une unité de supervision et interdit la fermeture du deuxième ensemble de contacteurs.

Il est proposé selon un deuxième aspect de l'invention, un pack batterie destiné à alimenter un moteur électrique d'un véhicule mû au moins partiellement par de l'énergie électrique comprenant au moins un module de batterie et un moyen de gestion pilotant le module de batterie. Le moyen de gestion met en œuvre le procédé de surveillance d'un défaut d'isolation dans un circuit de recharge du pack batterie tel que défini précédemment.

Il est proposé selon un troisième aspect de l'invention, un véhicule mû au moins partiellement par de l'énergie électrique comprenant un pack batterie tel que défini précédemment pour alimenter un moteur électrique.

L'invention fournit ainsi une solution permettant de détecter et de surveiller un défaut d'isolation dans un circuit de recharge d'un pack batterie plus efficacement.

L'isolation du circuit de recharge permettant une recharge rapide selon le mode 4 est contrôlée pendant le roulage du véhicule, ce qui permet au BMS de détecter directement si le défaut d'isolation provient du véhicule, contrairement aux solutions de l'art antérieurs qui ne permettent pas de distinguer s'il y a un défaut d'isolation du côté véhicule (circuit de recharge ou connecteur) ou du côté de la borne de recharge.

L'invention permet de détecter si le connecteur électrique du pack batterie présente de l'oxydation.

Les problèmes sont anticipés et la création d'un court-circuit dû à l'oxydation du connecteur lors d'une prochaine recharge rapide est évitée. Le véhicule est mieux protégé et les risques d'embrasement sont éliminés. Les coûts dus à des changements de circuit de recharge inutiles sont également supprimés.

De plus, l'invention fournit une aide au service après-vente qui peut détecter plus rapidement les pannes électriques et réparer.

D'autres caractéristiques et avantages de l'invention sont mis en évidence par la description ci-après d'exemples non limitatifs de réalisation des différents aspects de l'invention.

### BREVE DESCRIPTION DES FIGURES

D'autres caractéristiques et avantages de l'invention ressortiront à la lecture de la description qui suit, en référence à la figure unique annexée, qui illustre :

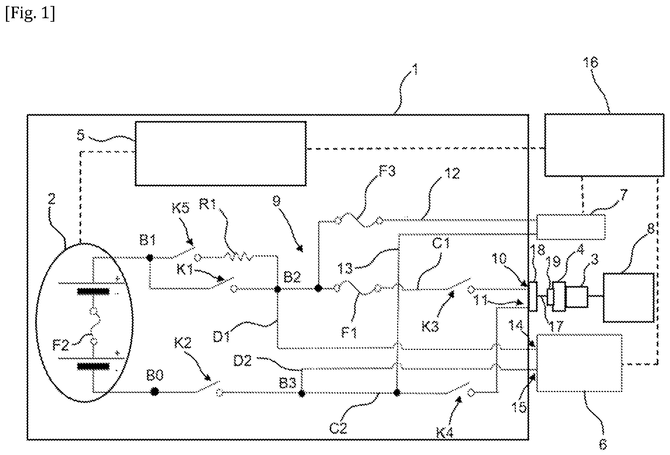

[Fig. 1] : un schéma d'un pack batterie selon un mode de réalisation de l'invention.

### DESCRIPTION DETAILLEE D'UN MODE DE REALISATION

La figure 1 ([Fig.1]) représente un pack batterie 1 destiné à alimenter un moteur électrique 6 (ou machine électrique) d'un véhicule électrique ou hybride, selon un mode de réalisation de l'invention.

Le pack batterie 1 comprend au moins un module de batterie 2 et un moyen de gestion 5 pilotant le module de batterie 2. Le module de batterie 2 est relié au moteur électrique 6 par un réseau de puissance 9 et plus précisément par un circuit de décharge D1, D2 du réseau de puissance 9. Le circuit de décharge D1, D2 comprend un premier ensemble de contacteurs K1, K2.

Le module de batterie 2 est également apte à être relié à une embase de recharge 4 par un circuit de recharge C1, C2 comprenant un deuxième ensemble de contacteurs K3, K4. L'embase de recharge 4 est destinée à être connectée à un pistolet de recharge 3 d'un dispositif de recharge électrique 8, tel une station ou une borne ou une prise de recharge, pour recharger le module de batterie 2.

Le pack batterie 1 comprend un premier connecteur électrique 18 relié au circuit de recharge C1, C2. Le premier connecteur électrique 18 est branché sur le pack batterie 1. Un câble ou faisceau électrique 17 comprenant des fils électriques relie le premier connecteur électrique 18 à un deuxième connecteur électrique 19 prévu sur l'embase de recharge 4.

Le moyen de gestion électrique 5 (ou électronique) des batteries aussi appelé calculateur de pilotage ou BMS (Acronyme en anglais de Battery Management System) est piloté par une unité de supervision du véhicule 16 eVCU (Acronyme en anglais de electronic Vehicle Control Unit).

L'unité de supervision du véhicule 16 supervise et coordonne les autres calculateurs intervenant dans le fonctionnement du groupe motopropulseur et à ce titre intervient ainsi également dans le contrôle du pack batterie 1. L'unité de supervision du véhicule 16 pilote entre autre un réseau de communication CAN (Acronyme en anglais de Controller Area Network), un moyen de contrôle du chargeur embarqué OBC (Acronyme en anglais de On Board Charging) et un moyen de contrôle de convertisseur 7 appelé OBCDC (Acronyme en anglais de On Board Charging DC-DC Converters).

Le moyen de contrôle de convertisseur 7 est composé de deux parties dont le moyen de contrôle du chargeur embarqué OBC et un convertisseur DC/DC qui est responsable de la conversion du courant.

Le moyen de contrôle du chargeur embarqué OBC est le chargeur de courant électrique du véhicule. L'OBC gère la communication avec les différentes bornes de recharge. L'OBC surveille et monitore également la recharge électrique du véhicule.

Le convertisseur DC/DC est responsable de la conversion du courant. Lors des recharges électriques selon des premier et deuxième modes de recharge domestique comme décrit ci-après, le convertisseur DC/DC convertit le courant alternatif 220V en courant continu jusque 450V sur les véhicules.

En roulage, le convertisseur DC/DC convertit le courant continue DC qui présente une tension de 450V en courant continu DC présentant une tension de 12V pour soutenir la tension du réseau de bord du véhicule et recharger la batterie de servitude de 12V. La batterie de servitude de 12V alimente la climatisation, la radio et l'éclairage habitacle, par exemple.

Le moyen de contrôle du convertisseur 7 appelé OBCDC est apte à prendre en charge plusieurs modes de recharge dont un premier mode de recharge domestique (appelé charge mode 2) sur une prise murale classique délivrant généralement un courant compris entre 8A et 13A sous la tension standard du réseau électrique domestique de 220V alternatif. Un deuxième mode de recharge (appelé charge mode 3) piloté par le moyen de contrôle du convertisseur 7 est la recharge du pack batterie 1 sur une wallbox (boîte murale en français). Cette wallbox est en général achetée avec le véhicule et installée sur le compteur du domicile de l'utilisateur du véhicule, c'est-à-dire qu'elle est alimentée en énergie électrique domestique, et elle délivre donc un courant en monophasé de 16A ou de 32A ou en triphasé de 16A sur chaque phase. La wallbox joue donc un rôle comparable à celui d'un convertisseur électrique. Dans ce cas on peut parler de deuxième mode de recharge ajusté.

Un troisième mode de recharge (appelé charge mode 4) sur des bornes spéciales délivrant généralement un courant continu de 40A à 250A ou plus sous une tension de 450V est quant à lui piloté par le moyen de gestion électrique 5 (BMS). Ce mode de recharge sur borne spéciale est aussi appelé mode de recharge rapide et est indépendant du réseau électrique domestique.

Le moyen de contrôle de convertisseur 7 (OBCDC) est composé de deux parties dont le moyen de contrôle du chargeur embarqué OBC et un convertisseur DC/DC qui est responsable de la conversion du courant.

Le moyen de contrôle du chargeur embarqué OBC est le chargeur de courant électrique du véhicule. L'OBC gère la communication avec les différentes bornes de recharge. L'OBC surveille et monitore également la recharge électrique du véhicule.

Le convertisseur DC/DC est responsable de la conversion du courant. Lors des recharges électriques selon les premier et deuxième modes, le convertisseur DC/DC convertit le courant alternatif 220V en courant continu jusque 450V sur les véhicules.

En roulage, le convertisseur DC/DC convertit le courant continue DC qui présente une tension de 450V en courant continu DC présentant une tension de 12V pour soutenir la tension du réseau de bord du véhicule et recharger la batterie de servitude de 12V. La batterie de servitude de 12V alimente la radio, les divers calculateurs du véhicule et l'éclairage habitacle, par exemple.

Le circuit de recharge C1, C2 comprend un chemin de recharge positif C1 connecté à une borne d'électrode positive B1 du module de batterie 2 et un chemin de recharge négatif C2 connecté à une borne d'électrode négative B0 du module de batterie 2.

Le chemin de recharge positif C1 comprend un premier contacteur K3 positionné entre la borne d'électrode positive B1 et une première borne 10 du premier connecteur électrique 18 et un deuxième contacteur K4 positionné entre la borne d'électrode négative B0 et une deuxième borne 11 du premier connecteur électrique 18.

On entend par « chemin » des chemins électriques pouvant comprendre des fils électriques ou des pistes ou équivalent.

Le circuit de décharge D1, D2 comprend un chemin de décharge positif D1 comprenant un premier contacteur K1 positionné entre la borne d'électrode positive B1 et une borne positive B2 reliée au moteur électrique 6.

Le circuit de décharge D1, D2 comprend un chemin de décharge négatif D2 comprenant un deuxième contacteur K2 positionné entre la borne d'électrode négative B0 et une borne négative B3 reliée au moteur électrique 6.

En variante, le chemin de décharge positif D1 peut également comprendre d'autres contacteurs électriques, tel un contacteur secondaire K5 relié à une résistance R1. Le contacteur secondaire K5 et la résistance R1 sont reliés entre la borne d'électrode positive B1 et la borne positive B2 et sont montés en parallèle avec le premier contacteur K1.

Le chemin de recharge positif C1 est relié au chemin de décharge positif D1 par la borne positive B2 et le chemin de recharge négatif C2 est relié au chemin de décharge négatif D2 par la borne négative B3.

Classiquement, lorsque le véhicule est en roulage, le premier contacteur K1 et le deuxième contacteur K2 sont fermés. Le troisième contacteur K3 et le quatrième contacteur K4 sont ouverts. Le module de batterie 2 est alors isolé de l'embase de recharge 4.

Lorsque le véhicule est en recharge rapide, le premier contacteur K1 et le deuxième contacteur K2 sont fermés. Le troisième contacteur K3 et le quatrième contacteur K4 sont fermés.

Le premier contacteur K1, le deuxième contacteur K2 et le premier contacteur secondaire K5 permettent d'isoler le module de batterie 2 du moteur électrique 6 lorsqu'ils sont ouverts.

Le réseau de puissance 9 peut également comprendre un premier chemin 12 reliant le moyen de contrôle du convertisseur 7 au chemin de décharge positif D1 et un deuxième chemin 13 reliant le moyen de contrôle du convertisseur 7 au chemin de décharge négatif D2.

Un premier fusible de protection F1 peut être prévu sur le chemin de recharge positif C1. Un deuxième fusible de protection F2 peut être également prévu dans le module de batterie 2. Et un troisième fusible de protection F3 peut être prévu sur le premier chemin 12 reliant le moyen de contrôle du convertisseur 7 au chemin de décharge positif D1.

Le réseau de puissance 9 comprend un réseau de fils électriques formant en partie les différents chemins précités qui sont des chemins électriques.

Le pack batterie 1 peut comprendre un système de refroidissement/réchauffage des modules d'énergie 2 et une armature de maintien des modules d'énergie 2 (non représentés).

L'invention concerne un procédé de surveillance d'un défaut d'isolation dans le circuit de recharge C1, C2 du pack batterie 1 comprenant une opération de détection du défaut d'isolation dans le circuit de recharge C1, C2 lors d'une phase de roulage du véhicule durant laquelle le deuxième ensemble de contacteurs K3, K4 est fermé pour relier électriquement le module de batterie 2 à l'embase de recharge 4.

Plus précisément, le premier contacteur K3 est fermé pour relier électriquement le chemin de décharge positif C1 à l'embase de recharge 4 et le deuxième contacteur K4 est fermé pour relier électriquement le chemin de décharge négatif C2 à l'embase de recharge 4, lors de l'opération de détection.

Pour permettre le roulage du véhicule, le premier contacteur K1 et le deuxième contacteur K2 sont également fermés.

Lors de l'opération de détection, le moyen de gestion 5 mesure un courant I et une tension U dans le circuit de recharge C1, C2 pour déterminer une résistance R d'après la relation R = U / I. Un défaut d'isolation dans le circuit de recharge C1, C2, c'est-à-dire dans le chemin de décharge positif C1 ou le chemin de décharge négatif C2, est détecté lorsque la résistance R mesurée est inférieure ou égale à une valeur de résistance seuil Rs prédéterminée. Il est déduit que le câble électrique 17 ou que le premier connecteur électrique 18 présente de l'oxydation.

Lorsque la résistance R mesurée est supérieure à une valeur de résistance seuil Rs prédéterminée, aucun défaut d'isolation n'est détecté.

La résistance seuil Rs est calibrée durant une phase de développement du véhicule et prend en compte l'environnement électrique dans le pack batterie 1. La résistance seuil Rs peut être de 300 kOhms, par exemple.

De préférence, le courant I et la tension U sont mesurés en sortie du pack batterie 1. Le courant I et la tension U peuvent être mesurés en sortie du pack batterie 1 entre la première borne 10 du premier connecteur électrique18 et la deuxième borne 11 du premier connecteur électrique18.

D'autres moyens alternatifs pour mesurer la résistance R peuvent être prévus comme un ohmmètre externe ou un procédé comprenant une mesure de température permettant de déduire la résistance.

Le moyen de gestion 5 peut mesurer le courant I et la tension U en sortie du pack batterie 1 en permanence. Cependant, l'opération de détection est réalisée pendant un temps de test T1 déterminé.

Le premier contacteur K3 et le deuxième contacteur K4 sont uniquement fermés pendant ce temps de test T1.

Le temps de test T1 peut correspondre au temps de fermeture du premier contacteur K3 et du deuxième contacteur K4. Le temps de test T1 peut être de 20 secondes, par exemple.

Le défaut d'isolation dans le circuit de recharge C1, C2 est détecté lorsque la résistance R mesurée est inférieure ou égale à la valeur de résistance seuil Rs pendant un temps T2, T2 étant inférieur au temps T1.

Le temps T2 est calibrée lors de la mise au point de la fonction et peut être de 10 secondes, par exemple.

Selon un mode de réalisation décrivant un procédé de surveillance plus global, le moyen de gestion 5 surveille en permanence l'ensemble du réseau de puissance 9 lors de la phase de roulage pour vérifier qu'il n'y ai pas un court-circuit sur le réseau de puissance 9 qui se déclenche et qui serait dangereux pour les utilisateurs. Ainsi, le moyen de gestion 5 mesure en permanence lors du roulage la résistance du réseau de puissance 9 du véhicule.

Selon une variante, le moyen de gestion 5 mesure la résistance du réseau de puissance 9 toutes les 10 millisecondes. Si la valeur de la résistance du réseau de puissance 9 passe sous la résistance seuil Rs avec le premier contacteur K3 et le deuxième contacteur K4 ouverts, le moyen de gestion 5 détecte un défaut d'isolation dans le réseau de puissance 9 et plus particulièrement dans le circuit de décharge D1, D2. Le moyen de gestion 5 isole alors électriquement le pack batterie 1 en ouvrant immédiatement le premier contacteur K1 et le deuxième contacteur K2 pour assurer la sécurité des passagers.

L'opération de détection d'un défaut d'isolation dans le circuit de recharge C1, C2 est rajoutée et vient en complément du procédé décrit précédemment. L'opération de détection est réalisée pendant un temps de test T1 court.

Ce temps de test T1 peut être périodique. La périodicité de test est calibrée lors de la mise au point de la fonction.

De préférence, l'opération de détection est réalisée une seule fois après le démarrage du véhicule.

Selon une variante, l'opération de détection peut être réalisée une seule fois après le démarrage du véhicule et après un temps T3 à compter du démarrage du véhicule qui peut être de 30 secondes, par exemple.

Selon une variante, l'opération de détection peut être réalisée plusieurs fois pendant le roulage du véhicule.

Alternativement, l'opération de détection est réalisée plusieurs fois à une fréquence calibrée lors de la phase de mise au point de la fonction et après le temps T3 après le démarrage du véhicule à une fréquence définie lors d'une phase de mise au point de la fonction.

Selon un exemple de procédé de surveillance, le moyen de gestion 5 mesure la résistance du réseau de puissance 9 toutes les 10 millisecondes lors du roulage du véhicule. Si la valeur de la résistance du réseau de puissance 9 reste au-dessus de la résistance seuil Rs avec le premier contacteur K3 et le deuxième contacteur K4 ouverts, le moyen de gestion 5 ne détecte pas de défaut d'isolation dans le réseau de puissance 9.

Toujours pendant le roulage du véhicule, l'opération de détection est réalisée. Le premier contacteur K3 est alors fermé pour relier électriquement le chemin de décharge positif C1 à l'embase de recharge 4 et le deuxième contacteur K4 est fermé pour relier électriquement le chemin de décharge négatif C2 à l'embase de recharge 4.

Le moyen de gestion 5 détecte un défaut d'isolation dans le circuit de recharge C1, C2 si la résistance R mesurée est inférieure ou égale à la valeur de résistance seuil Rs pendant le temps T2.

Il est déduit qu'il y a un problème d'oxydation sur le premier connecteur électrique 18 du pack batterie 1.

Lorsqu'un défaut d'isolation dans le circuit de recharge C1, C2 est détecté, le moyen de gestion 5 interdit la recharge du pack batterie 1.

De préférence, le moyen de gestion 5 interdit la recharge du pack batterie 1 en mode rapide selon le troisième mode de recharge (appelé charge mode 4) par un dispositif de recharge électrique 3 fournissant une intensité supérieure à 40 ampères. L'intensité fournie peut être également de 125 ampères ou 250 ampères, par exemple.

Selon un mode de réalisation, lorsqu'un défaut d'isolation est détecté dans le circuit de recharge C1, C2, le moyen de gestion 5 transmet une alerte à l'unité de supervision 16 et interdit la fermeture du deuxième ensemble de contacteurs K3, K4, c'est-à-dire du premier contacteur K3 et du deuxième contacteur K4.

Le moyen de gestion 5 remonte l'alerte avec un code défaut spécifique pour orienter le service après-vente vers un défaut d'isolation du circuit de recharge C1, C2 en charge rapide. Le service après-vente aura pour première consigne de vérifier entre autre le niveau d'oxydation du premier connecteur électrique 18 qui se branche sur le pack batterie 1. Le câble électrique 17 reliant le premier connecteur électrique 18 au deuxième connecteur électrique 19 de l'embase de recharge 4 et l'embase de recharge 4 seront également vérifiés.

L'unité de supervision 16 commande l'allumage d'un voyant « service » pour prévenir le conducteur qu'il faut passer au service après-vente pour faire vérifier le véhicule.

Comme dit précédemment, le moyen de gestion 5 enregistre le défaut d'isolation du circuit de recharge C1, C2 et interdit les recharges rapide en mode 4.

A chaque nouvelle recharge rapide, l'unité de supervision 16 demande au moyen de gestion 5 une autorisation pour procéder à la recharge rapide. Le moyen de gestion 5 interdit les recharges rapide tant que le service après-vente n'a pas effacer le défaut dans la mémoire du moyen de gestion 5.

Plus largement, le moyen de gestion 5 interdit toute nouvelle fermeture des contacteurs du deuxième ensemble de contacteurs K3, K4 tant que le service après-vente n'a pas effacer le défaut dans la mémoire du moyen de gestion 5 et empêche ainsi toute recharge rapide du pack batterie 1.

Naturellement, l'invention est décrite dans ce qui précède à titre d'exemple. Il est entendu que l'homme du métier est à même de réaliser différentes variantes de réalisation de l'invention sans pour autant sortir du cadre de l'invention telle que définie par les revendications suivantes.

## Revendications

1. Procédé de surveillance d'un défaut d'isolation dans un circuit de recharge (C1, C2) d'un pack batterie (1) destiné à alimenter un moteur électrique (6) d'un véhicule mû au moins partiellement par de l'énergie électrique, le pack batterie (1) comprenant au moins un module de batterie (2) et un moyen de gestion (5) pilotant le module de batterie (2), le module de batterie (2) étant apte à être relié au moteur électrique (6) par un circuit de décharge (D1, D2) comprenant un premier ensemble de contacteurs (K1, K2) et apte à être relié à une embase de recharge (4) par le circuit de recharge (C1, C2) comprenant un deuxième ensemble de contacteurs (K3, K4), l'embase de recharge (4) étant destiné à être connecté à un pistolet de recharge (3) d'un dispositif de recharge électrique (8) pour recharger le module de batterie (2), **caractérisé en ce qu'**il comprend une opération de détection du défaut d'isolation dans le circuit de recharge (C1, C2) lors d'une phase de roulage du véhicule durant laquelle le deuxième ensemble de contacteurs (K3, K4) est fermé pour relier électriquement le module de batterie (2) à l'embase de recharge (4), le premier ensemble de contacteurs (K1, K2) étant fermé pour relier électriquement le module de batterie (2) au moteur électrique (6) pour permettre le roulage.

2. Procédé de surveillance selon la revendication 1, **caractérisé en ce que** lors de l'opération de détection, le moyen de gestion (5) mesure un courant I et une tension U dans le circuit de recharge (C1, C2) pour déterminer une résistance R d'après la relation R = U / I, un défaut d'isolation dans le circuit de recharge (C1, C2) étant détecté lorsque la résistance R mesurée est inférieure ou égale à une valeur de résistance seuil Rs.

3. Procédé de surveillance selon la revendication 2, **caractérisé en ce que** le courant I et la tension U sont mesurés en sortie du pack batterie (1).

4. Procédé de surveillance selon l'une quelconque des revendications 1 à 3, **caractérisé en ce que** l'opération de détection est réalisée pendant un temps de test T1 déterminé, le défaut d'isolation dans le circuit de recharge (C1, C2) étant détecté lorsque la résistance R mesurée est inférieure ou égale à la valeur de résistance seuil Rs pendant un temps T2, T2 étant inférieur au temps T1.

5. Procédé de surveillance selon l'une quelconque des revendications 1 à 4, **caractérisé en ce que** le circuit de recharge (C1, C2) comprend un chemin de recharge positif (C1) connecté à une borne d'électrode positive (B1) du module de batterie (2) et un chemin de recharge négatif (C2) connecté à une borne d'électrode négative (B0) du module de batterie (2), le chemin de recharge positif (C1) comprenant un premier contacteur (K3) positionné entre la borne d'électrode positive (B1) et un premier connecteur électrique (18) relié à l'embase de recharge (4) et un deuxième contacteur (K4) positionné entre la borne d'électrode négative (B0) et le premier connecteur électrique (18), le premier contacteur (K3) étant fermé pour relier électriquement le chemin de décharge positif (C1) à l'embase de recharge (4) et le deuxième contacteur (K4) étant fermé pour relier électriquement le chemin de décharge négatif (C2) à l'embase de recharge (4), lors de l'opération de détection.

6. Procédé de surveillance selon l'une quelconque des revendications 1 à 5, **caractérisé en ce que** l'opération de détection est réalisée une seule fois après le démarrage du véhicule et après un temps T3 après le démarrage du véhicule.

7. Procédé de surveillance selon l'une quelconque des revendications 1 à 5, **caractérisé en ce que** l'opération de détection est réalisée plusieurs fois après le démarrage du véhicule et après un temps T3 après le démarrage du véhicule à une fréquence définie lors d'une phase de mise au point de la fonction.

8. Procédé de surveillance selon l'une quelconque des revendications 1 à 7, **caractérisé en ce que** lorsqu'un défaut d'isolation dans le circuit de recharge (C1, C2) est détecté, le moyen de gestion (5) interdit la recharge du pack batterie (1) en mode rapide.

9. Procédé de surveillance selon la revendication 8, **caractérisé en ce que** lorsqu'un défaut d'isolation dans le circuit de recharge (C1, C2) est détecté, le moyen de gestion (5) transmet une alerte à une unité de supervision (16) et interdit la fermeture du deuxième ensemble de contacteurs (K3, K4).

10. Pack batterie (1) destiné à alimenter un moteur électrique (6) d'un véhicule mû au moins partiellement par de l'énergie électrique comprenant au moins un module de batterie (2) et un moyen de gestion (5) pilotant le module de batterie (2), **caractérisé en ce que** ce moyen de gestion met en œuvre le procédé de surveillance d'un défaut d'isolation dans un circuit de recharge (C1, C2) du pack batterie (1) tel que défini selon l'une quelconque des revendications 1 à 9.

## Patentansprüche

1. Verfahren zur Überwachung eines Isolationsfehlers in einem Ladestromkreis (C1, C2) eines Batteriepakets (1), das dazu bestimmt ist, einen Elektromotor (6) eines Fahrzeugs anzutreiben, das zumindest teilweise mit elektrischer Energie angetrieben wird, wobei das Batteriepaket (1) mindestens ein Batteriemodul (2) und ein Verwaltungsmittel (5) umfasst, das das Batteriemodul (2) steuert, wobei das Batteriemodul (2) durch eine Entladeschaltung (D1, D2), die einen ersten Satz von Schützen (K1, K2) umfasst, mit dem Elektromotor (6) verbunden werden kann und durch die Ladeschaltung (C1, C2), die einen zweiten Satz von Schützen (K3, K4) umfasst, mit einer Ladestation (4) verbunden werden kann, wobei die Ladestation (4) dazu bestimmt ist, mit einer Ladepistole (3) eines elektrischen Ladegeräts (8) verbunden zu werden, um das Batteriemodul (2), **dadurch gekennzeichnet, dass** es einen Vorgang zum Erkennen des Isolationsfehlers im Ladekreis (C1, C2) während einer Fahrphase des Fahrzeugs umfasst , bei dem der zweite Satz Schütze (K3, K4) geschlossen ist , um das Batteriemodul (2) elektrisch mit der Ladestation (4) zu verbinden, während der erste Satz Schütze (K1, K2) geschlossen ist, um das Batteriemodul (2) elektrisch mit dem Elektromotor (6) zu verbinden und den Antrieb zu ermöglichen.

2. Überwachungsprozess nach Anspruch 1, **dadurch gekennzeichnet, dass** während des Erfassungsvorgangs die Verwaltungseinrichtung (5) einen Strom I und eine Spannung U in der Ladeschaltung (C1, C2) misst, um einen Widerstand R gemäß der Beziehung R = U / I zu bestimmen, wobei ein Isolationsfehler in der Ladeschaltung (C1, C2) erkannt wird, wenn der gemessene Widerstand R kleiner oder gleich einem Schwellenwiderstandswert Rs ist.

3. Überwachungsprozess nach Anspruch 2, **dadurch gekennzeichnet, dass** am Ausgang des Akkupacks (1) der Strom I und die Spannung U gemessen werden.

4. Überwachungsprozess nach einem der Ansprüche 1 bis 3, **dadurch gekennzeichnet, dass** der Erkennungsvorgang während einer festgelegten Testzeit T1 durchgeführt wird, wobei der Isolationsfehler im Ladestromkreis (C1, C2) erkannt wird, wenn der gemessene Widerstand R während einer Zeit T2 kleiner oder gleich dem Schwellenwiderstandswert Rs ist , wobei T2 kürzer als die Zeit T1 ist.

5. Überwachungsprozess gemäß einem der Ansprüche 1 bis 4, **dadurch gekennzeichnet, dass** die Ladeschaltung (C1, C2) einen positiven Ladepfad (C1), der mit einem positiven Elektrodenanschluss (B1) des Batteriemoduls (2) verbunden ist, und einen negativen Ladepfad (C2) umfasst, der mit einem negativen Elektrodenanschluss (B0) des Batteriemoduls (2) verbunden ist, wobei der positive Ladepfad (C1) einen ersten Schütz (K3), der zwischen dem positiven Elektrodenanschluss (B1) und einem ersten elektrischen Verbinder (18), der mit der Ladebasis (4) verbunden ist, positioniert ist, und einen zweiten Schütz (K4), der zwischen dem negativen Elektrodenanschluss (B0) und dem ersten elektrischen Verbinder (18) positioniert ist, umfasst, wobei während des Erkennungsvorgangs der erste Schütz (K3) geschlossen ist, um den positiven Entladepfad (C1) elektrisch mit der Ladebasis (4) zu verbinden, und der zweite Schütz (K4) geschlossen ist, um den negativen Entladepfad (C2) elektrisch mit der Ladebasis (4) zu verbinden.

6. Überwachungsverfahren nach einem der Ansprüche 1 bis 5, **dadurch gekennzeichnet, dass** der Erkennungsvorgang nur einmal nach dem Starten des Fahrzeugs und nach einer Zeit T3 nach dem Starten des Fahrzeugs durchgeführt wird.

7. Überwachungsprozess nach einem der Ansprüche 1 bis 5, **dadurch gekennzeichnet, dass** der Erkennungsvorgang wird nach dem Starten des Fahrzeugs und nach einer Zeit T3 nach dem Starten des Fahrzeugs mehrmals mit einer während einer Funktionsentwicklungsphase festgelegten Häufigkeit durchgeführt.

8. Überwachungsprozess nach einem der Ansprüche 1 bis 7, **dadurch gekennzeichnet, dass** wenn ein Isolationsfehler im Ladekreis (C1, C2) erkannt wird, verhindert die Verwaltungseinrichtung (5) das Wiederaufladen des Batteriepacks (1) im Schnellmodus.

9. Überwachungsprozess nach Anspruch 8, **dadurch gekennzeichnet, dass** die Verwaltungseinrichtung (5) bei Erkennung eines Isolationsfehlers im Ladekreis (C1, C2) eine Warnung an eine Überwachungseinheit (16) sendet und das Schließen der zweiten Gruppe von Schützen (K3, K4) verhindert.

10. Batteriepaket (1) zum Betreiben eines Elektromotors (6) eines Fahrzeugs, das zumindest teilweise mit elektrischer Energie angetrieben wird, mit mindestens einem Batteriemodul (2) und einer Verwaltungseinrichtung (5) zum Steuern des Batteriemoduls (2), **dadurch gekennzeichnet, dass** es das Verfahren zum Überwachen eines Isolationsfehlers in einem Ladekreis (C1, C2) des Batteriepakets (1) gemäß einem der Ansprüche 1 bis 9 implementiert.

## Claims

1. Method for monitoring an insulation fault in a charging circuit (C1, C2) of a battery pack (1) intended to power an electric motor (6) of a vehicle driven at least partially by electrical energy, the battery pack (1) comprising at least one battery module (2) and a management means (5) controlling the battery module (2), the battery module (2) being able to be connected to the electric motor (6) by a discharge circuit (D1, D2) comprising a first set of contactors (K1, K2) and able to be connected to a charging base (4) by the charging circuit (C1, C2) comprising a second set of contactors (K3, K4), the charging base (4) being intended to be connected to a charging gun (3) of an electric charging device (8) to recharge the battery module (2), **characterized in that** it comprises an operation of detecting the insulation fault in the recharging circuit (C1, C2) during a driving phase of the vehicle during which the second set of contactors (K3, K4) is closed to electrically connect the battery module (2) to the recharging base (4), the first set of contactors (K1, K2) being closed to electrically connect the battery module (2) to the electric motor (6) to allow driving.

2. Monitoring process according to claim 1, **characterized in that** during the detection operation, the management means (5) measures a current I and a voltage U in the recharging circuit (C1, C2) to determine a resistance R according to the relation R = U / I, an insulation fault in the recharging circuit (C1, C2) being detected when the measured resistance R is less than or equal to a threshold resistance value Rs .

3. Monitoring process according to claim 2, **characterized in that** the current I and the voltage U are measured at the output of the battery pack (1).

4. Monitoring process according to any one of claims 1 to 3, **characterized in that** the detection operation is carried out during a determined test time T1, the insulation fault in the recharging circuit (C1, C2) being detected when the measured resistance R is less than or equal to the threshold resistance value Rs during a time T2, T2 being less than the time T1.

5. Monitoring process according to any one of claims 1 to 4, **characterized in that** the charging circuit (C1, C2) comprises a positive charging path (C1) connected to a positive electrode terminal (B1) of the battery module (2) and a negative charging path (C2) connected to a negative electrode terminal (B0) of the battery module (2), the positive charging path (C1) comprising a first contactor (K3) positioned between the positive electrode terminal (B1) and a first electrical connector (18) connected to the charging base (4) and a second contactor (K4) positioned between the negative electrode terminal (B0) and the first electrical connector (18), the first contactor (K3) being closed to electrically connect the positive discharge path (C1) to the charging base (4) and the second contactor (K4) being closed to electrically connect the negative discharge path (C2) to the charging base (4), during the detection operation.

6. Monitoring method according to any one of claims 1 to 5, **characterized in that** the detection operation is carried out only once after starting the vehicle and after a time T3 after starting the vehicle.

7. Monitoring process according to any one of claims 1 to 5, **characterized in that** the detection operation is carried out several times after starting the vehicle and after a time T3 after starting the vehicle at a frequency defined during a function development phase.

8. Monitoring process according to any one of claims 1 to 7, **characterized in that** when an insulation fault in the charging circuit (C1, C2) is detected, the management means (5) prohibits the recharging of the battery pack (1) in fast mode.

9. Monitoring process according to claim 8, **characterized in that** when an insulation fault in the charging circuit (C1, C2) is detected, the management means (5) transmits an alert to a supervision unit (16) and prohibits the closing of the second set of contactors (K3, K4).

10. Battery pack (1) intended to power an electric motor (6) of a vehicle driven at least partially by electrical energy comprising at least one battery module (2) and a management means (5) controlling the battery module (2), **characterized in that** it implements the method of monitoring an insulation fault in a recharging circuit (C1, C2) of the battery pack (1) as defined according to any one of claims 1 to 9 .
